# FASCICULE DE BREVET EUROPEEN

(11) **EP 0 983 616 B1**
(45) Date de publication et mention de la délivrance du brevet: **29.01.2003**
(21) Numéro de dépôt: 98925729.0
(22) Date de dépôt: 15.05.1998
(51) Int. Cl.: H01P 1/04

(54) **PROCEDE ET DISPOSITIF POUR CONNECTER DEUX ELEMENTS MILLIMETRIQUES**
VERFAHREN UND VORRICHTUNG ZUM VERBINDEN ZWEIER MILLIMETERELEMENTE
METHOD AND DEVICE FOR CONNECTING TWO MILLIMETRIC ELEMENTS

(30) Priorité: 23.05.1997 FR 9706328
(43) Date de publication de la demande: 08.03.2000
(73) Titulaire: Thales, 75008 Paris (FR)
(72) Inventeur: CACHIER, Gérard, Thomson-CSF P.I., Prot. & Conseil, 94 117 Arcueil Cedex (FR); DADEN, Jean-Yves, Thomson-CSF P.I.,Prot. & Conseil, 94 117 Arcueil Cedex (FR); GRANCHER, Alain, Thomson-CSF P.I.,Prot. & Conseil, 94 117 Arcueil Cedex (FR)
(86) Numéro de dépôt international: FR9800981
(87) Numéro de publication internationale: WO98053518

(56) Documents cités:
- EP-A- 0 747 997
- GB-A- 2 193 848
- US-A- 4 816 789
- US-A- 5 469 130
- PATENT ABSTRACTS OF JAPAN vol. 12, no. 217 (E-624), 21 juin 1988 & JP 63 013401 A (MITSUBISHI ELECTRIC CORP), 20 janvier 1988
- NELSON S ET AL: "OPTIMUM MICROSTRIP INTERCONNECTS" MTT-S INTERNATIONAL MICROWAVE SYMPOSIUM DIGEST, BOSTON, JUNE 10 - 14, 1991, vol. 3, 10 juin 1991, pages 1071-1074, XP000260308 HEITER G L

## Description

La présente invention se rapporte à un procédé et un dispositif de connexion de deux éléments millimétriques. Les éléments millimétriques sont mis en oeuvre avec des signaux dont la fréquence est typiquement supérieure à 30 GHz.

Elle permet en particulier de connecter deux éléments millimétriques consistant en un circuit millimétrique réalisé sur un circuit imprimé mettant en oeuvre des lignes conductrices du type microruban.

Les circuits imprimés sur lesquels sont réalisés les circuits millimétriques contiennent des lignes de propagation qui sont principalement de deux types.

Le premier type est dit coplanaire. Dans ce cas, le circuit imprimé met en oeuvre des lignes coplanaires. Une ligne coplanaire consiste en une ligne conductrice entourée par deux plans de masse situés symétriquement de part et d'autre de la ligne conductrice ; la ligne conductrice et les plans de masse étant situés sur une même face du substrat du circuit imprimé. Les connexions entre circuits millimétriques sont réalisées par des fils. Ces connexions peuvent introduire des perturbations lorsque les circuits à connecter sont trop éloignés. En effet, un champ électrique se développe horizontalement entre le conducteur central, relié à la ligne conductrice, et les conducteurs latéraux, situés de part et d'autre, reliés aux plans de masse. L'impédance caractéristique de cette ligne de propagation est déterminée principalement par le rapport entre la largeur du conducteur et la largeur de l'espace entre le conducteur central et les conducteurs latéraux, ainsi que par la constante diélectrique du support qui est l'air.

Le second type est dit microruban. Dans ce cas, le circuit imprimé met en oeuvre des lignes microrubans. Le circuit imprimé comporte ainsi un substrat diélectrique avec deux faces principales, une supérieure et une inférieure. Un conducteur ayant la forme d'un ruban est réalisé sur la face supérieure et un conducteur de masse est réalisé sur toute la face inférieure. Suivant cette disposition un champ électrique se développe entre le conducteur en ruban et le conducteur de masse. Lors de la réalisation d'un dispositif hyperfréquence, différents éléments millimétriques sont disposés dans une carcasse métallique spécifique. Les éléments millimétriques peuvent consister en des circuits millimétriques réalisés sur un circuit imprimé, en des substrats ou en des composants. Chaque élément millimétrique est rapporté sur une semelle vissée sur la carcasse métallique. Dans ces conditions, la continuité de masse se fait d'une part par soudure ou par collage conducteur sur toute la surface du circuit imprimé et d'autre part par le vissage de la semelle sur la carcasse métallique. Dans le domaine des fréquences millimétriques la continuité de masse du dispositif hyperfréquence décrit précédemment peut ne pas être de qualité suffisante. En particulier, lorsque la continuité de masse est assurée par contact, entre un boîtier vissé sur la carcasse et la carcasse par exemple, celle-ci peut ne pas être de bonne qualité, si le vissage est insuffisant ou si les surfaces en contact ne sont pas parfaitement planes, par exemple. Par ailleurs, lorsque deux circuits millimétriques à connecter sont éloignés, les techniques décrites précédemment peuvent ne pas être utilisables.
Le document D1 : ABSTRACTS OF JAPAN vol. 12, n°.217 (E-624), 21 juin 1998 divulgue un procédé pour connecter deux éléments millimétriques. Chaque élément comporte un conducteur de masse, une extrémité de masse située dans le prolongement de ce conducteur et des rubans conducteurs permettant de relier les extrémités de masse d'un premier élément millimétrique à celle d'un deuxième élément millimétrique ainsi que la connexion des lignes conductrices. Le signal HF passe du conducteur de masse du premier élément millimétrique vers le conducteur de masse du deuxième élément millimétrique via les extrémités de masse ponctuelles et les rubans conducteur.

Le but de l'invention est de pallier les inconvénients précités.

L'invention conceme un procédé de connexion d'un premier et d'un deuxième éléments millimétriques réalisés sur un substrat diélectrique présentant une face supérieure et une face inférieure, délimité à une extrémité par un bord de longueur déterminée et comportant au moins un chant et équipé d'un circuit imprimé mettant en oeuvre des lignes conductrices interagissant avec un plan de masse, comportant une étape de sélection d'une première ligne conductrice appartenant au premier élément millimétrique et une deuxième ligne conductrice appartenant au deuxième élément millimétrique, une étape de réalisation sur la face supérieure du substrat diélectrique du premier élément millimétrique, de part et d'autre d'une extrémité de la première ligne conductrice d'au moins deux zones de connexion mises au potentiel du plan de masse et réparties le long du bord du substrat diélectrique et réaliser de manière analogue suivant une même répartition un même nombre de zones de connexion sur la face supérieure du substrat diélectrique du deuxième élément millimétrique et de part et d'autre d'une extrémité de la ligne conductrice, une étape de connexion de la première ligne conductrice à la deuxième ligne conductrice et chacune des zones de connexion prise individuellement du premier circuit millimétrique à une zone de connexion et une seule du deuxième circuit millimétrique au moyen de liens déterminés caractérisé en ce que les zones de connexion sont mises au potentiel de masse par une métallisation déposée sur l'ensemble du chant situé au-desous du bord à l'exception d'une zone située à l'aplomb de la ligne conductrice.

Les lignes conductrices sont par exemple de type microruban.

Les liens déterminés peuvent être des fils d'or ou des fils soudés ou encore réalisés par un dispositif consistant en des fils découpés par photogravure sur une petite plaque et rapportés par soudure électrique sur le premier élément millimétrique puis soudés au deuxième élément millimétrique par une technique de soudure à la vague ou de soudure en phase vapeur.

Les liens déterminés peuvent aussi consister en au moins une ligne coplanaire consistant en une ligne conductrice bordée par un premier et un deuxième plans de masse, réalisée sur un substrat à forte constante diélectrique, dimensionnée pour posséder une impédance caractéristique déterminée.

L'invention concerne aussi un élément millimétrique selon la revendication 7.

Les lignes conductrices sont par exemple de type microruban.

L'invention sera bien comprise et ses avantages et inconvénients apparaîtront plus clairement lors de la description suivante présentée à titre d'illustration non limitative et faite en regard des figures suivantes :
- la figure 1, une extrémité d'un premier circuit millimétrique,
- la figure 2, une vue en coupe du circuit millimétrique de la figure 1,
- la figure 3, une extrémité d'un deuxième circuit millimétrique,
- la figure 4, une vue en coupe du circuit millimétrique de la figure 3,
- la figure 5, deux circuits millimétriques connectés suivant un procédé selon l'invention,
- la figure 6, un dispositif qui connecte, selon un procédé selon l'invention, un premier circuit millimétrique à un deuxième circuit millimétrique,
- la figure 7, une vue en coupe de l'ensemble représenté sur la figure 6,
- la figure 8, un élément millimétrique monté suivant une technique composants montés en surface et connecté à un substrat selon un procédé selon l'invention.

Sur les différentes figures, les éléments homologues sont représentés avec une même référence numérique.

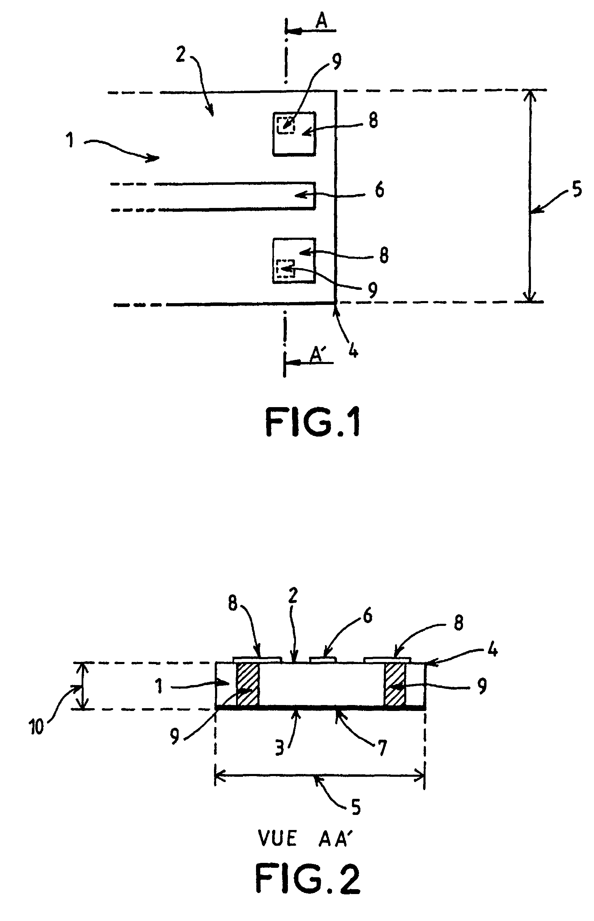

Les figures 1 et 2 représentent une extrémité d'un circuit imprimé d'un circuit millimétrique. La figure 2 est une vue en coupe suivant l'axe AA' du circuit imprimé représenté sur la figure 1. Le circuit imprimé est réalisé sur un substrat diélectrique 1 ayant une face supérieure 2 et une face inférieure 3. L'extrémité représentée du substrat diélectrique 1 se termine par un bord 4 de longueur 5 déterminée, de l'ordre de 5 mm par exemple. Le circuit millimétrique réalise entre au moins un premier et un deuxième points particuliers une fonction particulière, de filtrage par exemple. Pour réaliser cette fonction particulière le circuit millimétrique peut comprendre, par exemple, des composants, non représentés, tels des condensateurs, des cadre de l'invention, les fréquences mises en oeuvre sont préférentiellement supérieures à 30 GHz. Compte tenu des problèmes particuliers liés aux hyperfréquences, les circuits imprimés des circuits millimétriques mettent en oeuvre des lignes de propagation. Une ligne de propagation est réalisée par une ligne conductrice qui interagit avec un plan de masse. Le circuit imprimé représenté sur les figures 1 et 2 met en oeuvre des lignes conductrices de type microruban. Suivant ce type, une ligne conductrice est un conducteur 6, ayant la forme d'un ruban, situé sur la face supérieure 2 du substrat diélectrique 1. Le conducteur 6 interagit avec un plan de masse 7 qui recouvre toute la face inférieure 3 du substrat diélectrique 1, produisant un champ électrique entre le conducteur 6 et le plan de masse 7. Pour connecter le premier circuit millimétrique, représenté figures 1 et 2 à un deuxième circuit millimétrique, non représenté, une première ligne conductrice est sélectionnée sur le premier circuit millimétrique, le conducteur 6, lors d'une première étape.

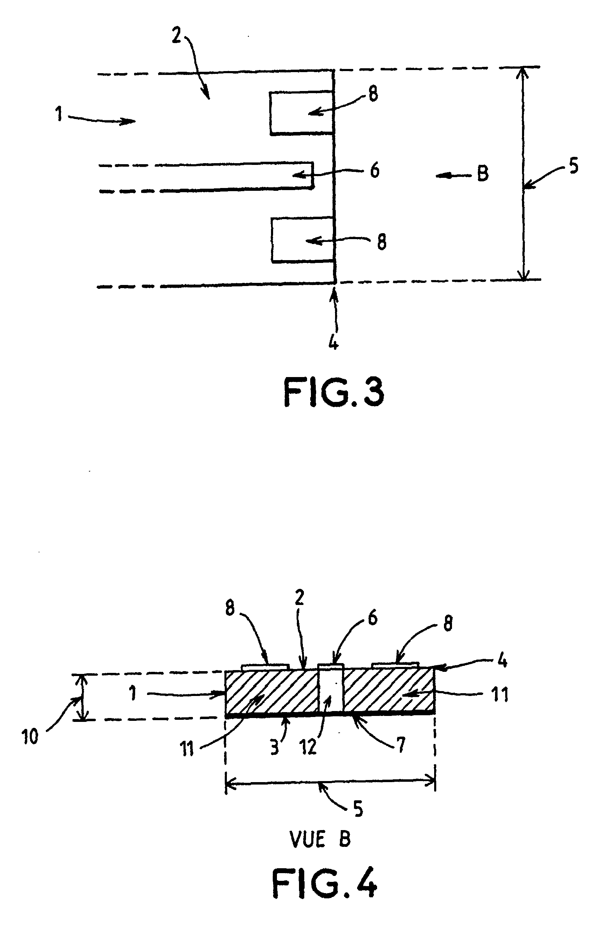

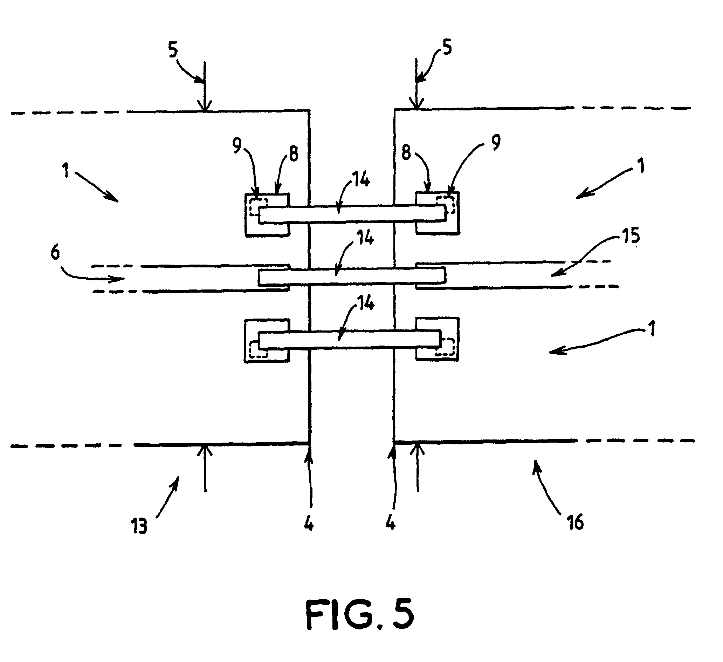

L'étape suivante consiste à réaliser au moins deux zones de connexion 8 sur la face supérieure 2 du substrat diélectrique 1 de part et d'autre d'une extrémité de la première ligne conductrice sélectionnée, le conducteur 6. Ces zones de connexion 8 ont la particularité d'être mises au potentiel du plan de masse 7. Selon l'exemple choisi et illustré par les figures 1 et 2, la mise au potentiel du plan de masse 7 des zones de connexion 8 est réalisée par une traversée métallisée 9 traversant l'épaisseur 10 du substrat diélectrique 1. Suivant le procédé selon l'invention, la mise au potentiel du plan de masse 7 des zones de connexion 8 est réalisée par une métallisation sur un chant du substrat diélectrique 1, comme illustré sur les figures 3 et 4. La figure 4 est une vue de côté de la figure 3, suivant la flèche B. Le chant retenu est préférentiellement celui situé en dessous du bord 4. Pour ne pas créer de capacité de bout supplémentaire, les parties métallisées 11 du chant couvrent l'ensemble du chant à l'exception de la zone 12 du chant située à l'aplomb du conducteur 6. Les zones de connexion 8 sont positionnées le long du bord 4 du substrat diélectrique 1 afin qu'il y ait une continuité électrique entre les zones de connexion 8 et les parties métallisées 11 du chant. La dernière étape du procédé est décrite en regard de la figure 5.

La première ligne conductrice 6, sélectionnée préalablement, appartenant à un premier circuit millimétrique 13 est connectée selon un premier mode de réalisation, au moyen de fils d'or 14, à une deuxième ligne conductrice 15 appartenant à un deuxième circuit millimétrique 16. Chacune des zones de connexion 8 prise individuellement du premier circuit millimétrique 13 est connectée, au moyen d'un fil d'or 14, à une et une seule zone de connexion 8 du deuxième circuit millimétrique 16. Sur l'exemple représenté sur la figure 5, chaque circuit millimétrique 13, 16 est équipé de deux zones de connexion 8, réparties le long du bord 4 du substrat diélectrique 1. La connexion par fils d'or, illustrée sur la figure 5, peut ne pas être possible lorsque, par exemple les deux circuits millimétriques à connecter sont trop éloignés. Selon un deuxième mode de réalisation, les connections entre le premier et le deuxième circuits millimétriques sont réalisés par des fils soudés. Selon un troisième mode de réalisation, les connections entre le premier et le deuxième circuits millimétriques sont réalisés par un dispositif particulier connu sous l'appellation anglosaxonne « lead frame ». Ce dispositif consiste en des fils découpés par photogravure sur une petite plaque. Lors du procédé les fils sont soudés par soudure électrique sur le premier circuit millimétrique puis ils sont soudés sur le deuxième circuit millimétrique suivant une technique particulière du type soudure à la vague ou du type soudure en phase vapeur par exemple.

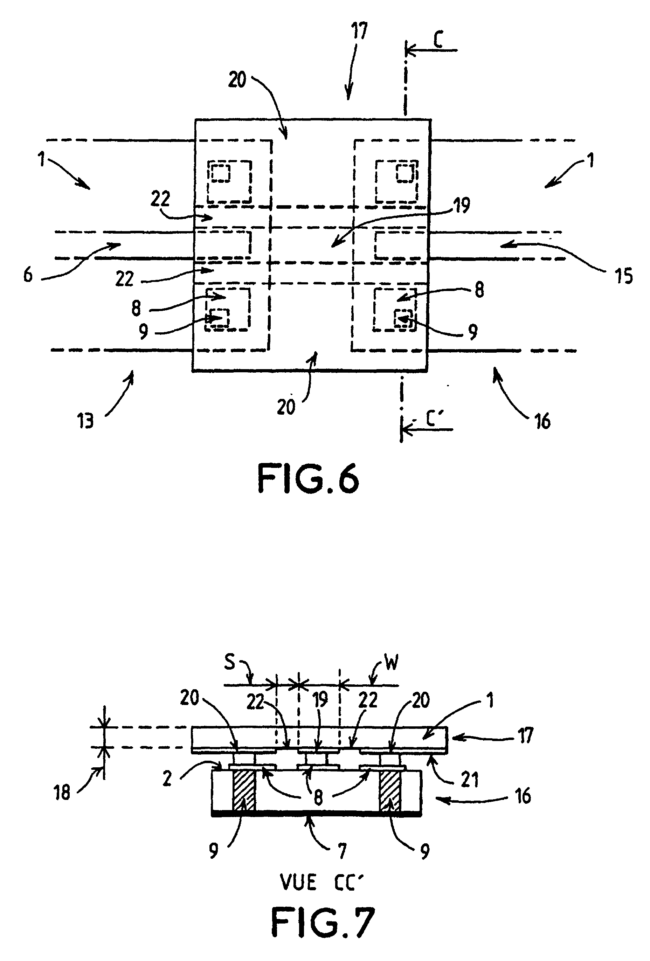

Une variante au procédé permet de remédier à la difficulté de connection que ne permet pas de résoudre les trois modes de réalisation précédents. La variante est illustrée par les figures 6 et 7. La figure 7 est une vue en coupe suivant l'axe CC' du circuit millimétrique représenté sur la figure 6. Selon cette variante, la connexion entre deux circuits millimétriques 13 et 16 est réalisée par une ligne coplanaire 17. La ligne coplanaire 17 est réalisée sur un substrat 1, d'épaisseur 18 déterminée et à forte constante diélectrique, tel qu'une alumine. La ligne coplanaire 17 est formée par une ligne conductrice 19 de largeur W déterminée bordée par deux plans de masse 20 situés symétriquement de part et d'autre de la ligne conductrice 19 sur une même face supérieure 21 du substrat. La ligne conductrice 19 et les deux plans de masse 20 peuvent être obtenus par dépôt de couches minces photogravées. La ligne conductrice 19 est séparée de chacun des deux plans de masse 20 par un espace 22 non métallisé de largeur S déterminée. Préférentiellement les valeurs de la largeur W de la ligne conductrice 19, de la largeur S de l'espace 22 séparant la ligne conductrice 19 des deux plans de masse 20 et de la constante diélectrique du substrat 1 sont déterminées de manière à ce que la ligne coplanaire 17 possède une impédance caractéristique identique à l'impédance caractéristique des lignes conductrices 6 et 15 appartenant aux circuits millimétriques 13 et 16 à connecter, par exemple 50 Ohms. La ligne coplanaire 17 est disposée sur les deux circuits millimétriques 13 et 16 à connecter avec la face supérieure 21 en regard des faces supérieures 2 des deux circuits millimétriques 13 et 16. Elle est ensuite soudée par une technique telle que celles utilisées pour souder des CMS, abréviation pour Composants Montés en Surface, par exemple une technique de soudure à la vague. A l'issue de l'opération de soudure, une continuité électrique de très bonne qualité est assurée entre les lignes conductrices 6 et 15 des deux circuits millimétriques 13 et 16 et entre les zones de connexion 8 des deux circuits millimétriques 13 et 16.

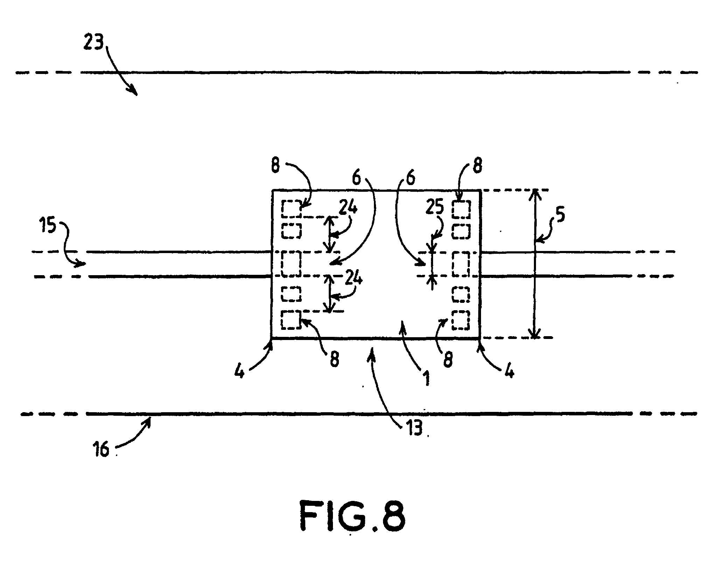

Dans certaines configurations, notamment celles relatives aux techniques de montages en surface, les plans de masse des éléments millimétriques à connecter ensemble peuvent ne pas être situés dans un même plan géométrique. Dans ces conditions, la connection des éléments millimétriques est réalisée suivant un mode particulier de réalisation du procédé. Dans le cas d'un élément millimétrique reporté sur un substrat, après sélection des lignes conductrices et réalisation des zones de connexion, les connections entre lignes conductrices et zones de connexion sont réalisées directement par soudure, du type soudure à la vague par exemple. Dans une étape de préparation du procédé un trou est réalisé dans le substrat pour éviter tout problème mécanique ou électrique lors du report de l'élément millimétrique sur le substrat. Dans ces configurations et sous certaines conditions, des défauts de continuité de masse peuvent apparaître. Ils perturbent le champ électrique locale et détériorent les performances de l'élément millimétrique. Une variante au procédé permet de remédier à ce problème. Suivant l'illustration donnée figure 8, des zones de connexion 8 sont réparties tout le long d'un bord 4 du substrat diélectrique 1 de l'élément millimétrique 13 rapporté, de même qu'en vis à vis sur le substrat de report 23. En particulier deux zones de connexion 8 supplémentaires sont réalisées à une grande distance 24 de la ligne conductrice 6. Cette distance 24 est telle que les zones de connexion 8 supplémentaires sont situées dans les angles du substrat diélectrique 1 de l'élément millimétrique 13 rapporté lorsque la largeur 5 du substrat diélectrique 1 est comprise entre environ trois fois la largeur 25 de la ligne conductrice 6 et cent fois cette même largeur 25.

Le procédé de connexion a essentiellement été décrit en regard de circuits millimétriques mettant en oeuvre des lignes conductrices de type microruban.

## Revendications

1. Procédé de connexion d'un premier (13) et d'un deuxième (16) éléments millimétriques réalisés sur un substrat diélectrique (1) présentant une face supérieure (2) et une face inférieure (3), délimité à une extrémité par un bord (4) de longueur déterminée (5) et comportant un chant (11) et équipé d'un circuit imprimé mettant en oeuvre des lignes conductrices (6, 15) interagissant avec un plan de masse (7), comportant une étape de sélection d'une première ligne conductrice (6) appartenant au premier élément millimétrique (13) et d'une deuxième ligne conductrice (15) appartenant au deuxième élément millimétrique (16), une étape de réalisation sur la face supérieure (2) du substrat diélectrique (1) du premier élément millimétrique (13), de part et d'autre d'une extrémité de la première ligne conductrice (6), d'au moins deux zones de connexion (8) mises au potentiel du plan de masse (7) et réparties le long du bord (4) du substrat diélectrique (1) et réaliser de manière analogue suivant une même répartition un même nombre de zones de connexion (8) sur la face supérieure (2) du substrat diélectrique (1) du deuxième élément millimétrique (16) et de part et d'autre d'une extrémité de la ligne conductrice (15), une étape de connexion de la première ligne conductrice (6) à la deuxième ligne conductrice (15) et de chacune des zones de connexion (8) prise individuellement du premier circuit millimétrique (13) à une zone de connexion (8) et une seule du deuxième circuit millimétrique (16) au moyen de liens déterminés (14, 17) **caractérisé en ce que**
les zones de connexion (8) sont mises au potentiel de masse (7) par une métallisation déposée sur l'ensemble du chant (11) situé au-dessous du bord (4) à l'exception d'une zone (12) située à l'aplomb de la ligne conductrice (6, 15).

2. Procédé selon la revendication 1 **caractérisé en ce que** les lignes conductrices (6, 15) sont de type microruban.

3. Procédé selon l'une des revendications 1 et 2 **caractérisé en ce que** les liens déterminés sont des fils d'or (14).

4. Procédé selon l'une des revendications 1 et 2 **caractérisé en ce que** les liens déterminés sont des fils soudés.

5. Procédé selon l'une des revendications 1 et 2 **caractérisé en ce que** les liens déterminés sont réalisés par un dispositif consistant en des fils découpés par photogravure sur une petite plaque et rapportés par soudure électrique sur le premier élément millimétrique puis soudés au deuxième élément millimétrique par une technique de soudure à la vague ou de soudure en phase vapeur.

6. Procédé selon l'une de revendications 1 et 2 **caractérisé en ce que** les liens déterminés consistent en au moins une ligne coplanaire (17) consistant en une ligne conductrice (19) bordée par un premier et un deuxième plans de masse (20), réalisée sur un substrat à forte constante diélectrique, dimensionnée pour posséder une impédance caractéristique déterminée.

7. Elément millimétrique réalisé sur un substrat diélectrique (1) présentant une face supérieure (2) et une face inférieure (3), delimité à une extremité par un bord (4) de longueur determinée (5) et comportant un chant (11), un plan de masse (7), une ligne conductrice (6, 15) disposée sur la face supérieure (2), au moins deux zones de connexion (8) mises au potentiel du plan de masse (7) disposées de part et d'autre d'une extrémité de la ligne conductrice (6, 15), et réparties le long du bord du substrat diélectrique, **caractérisé en ce que** l'ensemble du chant (11) situé en dessous du bord (4) est métallisé sur son ensemble excepté sur une zone (12) située à l'aplomb de la ligne conductrice (6), et les zones de connexion (8) sont mises au potentiel de masse (7) par la métallisation déposée sur l'ensemble du chant (11).

8. Elément selon la revendication 7 **caractérisé en ce que** les lignes conductrices (6, 15) sont de type microruban.

## Patentansprüche

1. Verfahren zum Verbinden eines ersten (13) und eines zweiten (16) Millimeterelements, die auf einem dielektrischen Substrat (1) verwirklicht sind, das eine obere Fläche (2) und eine untere Fläche (3) aufweist, an einem Ende durch einen Rand (4) mit bestimmter Länge (5) begrenzt ist, eine Schmalseite (11) aufweist und mit einer gedruckten Schaltung versehen ist, die Leiterbahnen (6, 15) verwendet, die mit einer Masseebene (7) in Wechselwirkung stehen, wobei das Verfahren umfaßt: einen Schritt, bei dem eine erste Leiterbahn (6), die zu dem ersten Millimeterelement (13) gehört, und eine zweite Leiterbahn (15), die zu dem zweiten Millimeterelement (16) gehört, ausgewählt werden, einen Schritt, bei dem auf der oberen Fläche (2) des dielektrischen Substrats (1) des ersten Millimeterelements (13) beiderseits eines Endes der ersten Leiterbahn (6) wenigstens zwei Verbindungszonen (8) ausgebildet werden, die auf dem Potential der Masseebene (7) liegen und längs des Randes (4) des dielektrischen Substrats (1) verteilt sind, und bei dem in analoger Weise mit der gleichen Verteilung die gleiche Anzahl von Verbindungszonen (8) auf der oberen Fläche (2) des dielektrischen Substrats (1) des zweiten Millimeterelements (16) und beiderseits eines Endes der Leiterbahn (15) verwirklicht werden, und einen Schritt, bei dem mittels bestimmter Verbindungen (14, 17) die erste Leiterbahn (6) mit der zweiten Leiterbahn (15) verbunden wird und jede der Verbindungszonen (8) der ersten Millimeterschaltung (13) einzeln mit einer Verbindungszone (8) und einer einzigen zweiten Millimeterschaltung (16) verbunden werden, **dadurch gekennzeichnet, daß**
die Verbindungszonen (8) durch eine Metallisierung, die auf der gesamten Schmalseite (11) unterhalb des Randes (4) mit Ausnahme einer Zone (12), die sich senkrecht unter der Leiterbahn (6, 15) befindet, aufgebracht ist, auf Massepotential (7) gelegt werden.

2. Verfahren nach Anspruch 1, **dadurch gekennzeichnet, daß** die Leiterbahnen (6, 15) vom Mikrostreifentyp sind.

3. Verfahren nach einem der Ansprüche 1 und 2, **dadurch gekennzeichnet, daß** die bestimmten Verbindungen Golddrähte (14) sind.

4. Verfahren nach einem der Ansprüche 1 und 2, **dadurch gekennzeichnet, daß** die bestimmten Verbindungen Lötdrähte sind.

5. Verfahren nach einem der Ansprüche 1 und 2, **dadurch gekennzeichnet, daß** die bestimmten Verbindungen durch eine Vorrichtung verwirklicht sind, die aus Drähten besteht, die durch Photoätzung auf einer kleinen Platte durchgeschnitten und durch Elektroschweißen mit dem ersten Millimeterelement verbunden werden und dann mit dem zweiten Millimeterelement durch eine Schwallöt- oder Dampfphasenlöt-Technik verlötet werden.

6. Verfahren nach einem der Ansprüche 1 und 2, **dadurch gekennzeichnet, daß** die bestimmten Verbindungen aus wenigstens einer koplanaren Leitung (17) bestehen, die aus einer Leiterbahn (19) besteht, die durch eine erste und eine zweite Masseebene (20) begrenzt, auf einem Substrat mit hoher Dielektrizitätskonstante verwirklicht und so dimensioniert ist, daß sie eine bestimmte charakteristische Impedanz besitzt.

7. Millimeterelement, das auf einem dielektrischem Substrat (1) verwirklicht ist, das eine obere Fläche (2) und eine untere Fläche (3) aufweist, an einem Ende durch einen Rand (4) mit bestimmter Länge (5) begrenzt ist und eine Schmalseite (11), eine Masseebene (7), eine auf der oberen Fläche (2) angeordnete Leiterbahn (6, 15), sowie wenigstens zwei Verbindungszonen (8) umfaßt, die auf das Potential der Masseebene (7) gelegt, beiderseits eines Endes der Leiterbahn (6, 15) angeordnet und längs des Randes des dielektrischen Substrats verteilt sind, **dadurch gekennzeichnet, daß** die gesamte Schmalseite (11), die sich unter dem Rand (4) befindet, mit Ausnahme einer Zone (12), die sich senkrecht unter der Leiterbahn (6) befindet, mit einer Metallisierung versehen ist und die Verbindungszonen (8) durch die auf die gesamte Schmalseite (11) aufgebrachte Metallisierung auf das Massepotential (7) gelegt sind.

8. Element nach Anspruch 7, **dadurch gekennzeichnet, daß** die Leiterbahnen (6, 15) vom Mikrostreifentyp sind.

## Claims

1. Process for bonding a first (13) and a second (16) millimetre element made on a dielectric substrate (1), exhibiting an upper face (2) and a lower face (3), which substrate is delimited at one end by an edge (4) of determined length (5) and comprising a rim (11) and equipped with a printed circuit implementing conducting lines (6, 15) interacting with an earth plane (7), comprising a step of selecting a first conducting line (6) belonging to the first millimetre element (13) and a second conducting line (15) belonging to the second millimetre element (16), a step of making on the upper face (2) of the dielectric substrate (1) of the first millimetre element (13), on either side of one end of the first conducting line (6), at least two bonding zones (8) set to the potential of the earth plane (7) and distributed along the edge (4) of the dielectric substrate (1) and to make in a similar manner according to the same distribution the same number of bonding zones (8) on the upper face (2) of the dielectric substrate (1) of the second millimetre element (16) and, on either side of one end of the conducting line (15), a step of bonding the first conducting line (6) to the second conducting line (15) and each of the bonding zones (8), taken individually, of the first millimetre circuit (13) to a bonding zone (8) and one only of the second millimetre circuit (16) by means of determined connections (14, 17), **characterized in that** the bonding zones (8) are set to the earth potential (7) by a metallization deposited on the whole of the rim (11) situated beneath the edge (4) with the exception of a zone (12) situated plumb with the conducting line (6, 15).

2. Process according to Claim 1, **characterized in that** the conducting lines (6, 15) are of the microstrip type.

3. Process according to either of Claims 1 and 2, **characterized in that** the determined connections are gold wires (14).

4. Process according to either of Claims 1 and 2, **characterized in that** the determined connections are soldered wires.

5. Process according to either of Claims 1 and 2, **characterized in that** the determined connections are made by a device consisting of wires photoetched onto a small plate and attached by electric soldering to the first millimetre element then soldered to the second millimetre element by a technique of wave soldering or of vapour phase soldering.

6. Process according to either of Claims 1 and 2, **characterized in that** the determined connections consist of at least one coplanar line (17), consisting of a conducting line (19) bordered by a first and a second earth plane (20), which line is made on a substrate with a high dielectric constant, and is dimensioned so as to possess a determined characteristic impedance.

7. Millimetre element made on a dielectric substrate (1) exhibiting an upper face (2) and a lower face (3), and delimited at one end by an edge (4) of determined length (5) and comprising a rim (11), an earth plane (7), a conducting line (6, 15) disposed on the upper face (2), at least two bonding zones (8) set to the potential of the earth plane (7), disposed on either side of one end of the conducting line (6, 15) and distributed along the edge of the dielectric substrate, **characterized in that** the whole of the rim (11) situated beneath the edge (4) is metallized over the whole thereof except on a zone (12) situated plumb with the conducting line (6), and the bonding zones (8) are set to the earth potential (7) by the metallization deposited on the whole of the rim (11).

8. Element according to Claim 7, **characterized in that** the conducting lines (6, 15) are of microstrip type.
